# FASCICULE DE BREVET EUROPEEN

(11) **EP 2 330 879 B1**
(45) Date de publication et mention de la délivrance du brevet: **28.03.2018**
(21) Numéro de dépôt: 10193379.4
(22) Date de dépôt: 01.12.2010
(51) Int. Cl.: H05K 7/14

(54) **Cabinet pour équipement avionique**
Kleiner Raum für Flugzeugausrüstung
Cabinet for avionics equipment

(30) Priorité: 01.12.2009 FR 0958560
(43) Date de publication de la demande: 08.06.2011
(73) Titulaire: Airbus Operations, 31060 Toulouse (FR)
(72) Inventeur: Colongo, Emile, 31310, Montesquieu Volvestre (FR); Roujean, Olivier, 31200, Toulouse (FR)
(74) Mandataire: Santarelli

(56) Documents cités:
- EP-A2- 1 011 300
- DE-A1- 10 330 277
- FR-A1- 2 651 636
- US-A- 4 646 202
- US-A- 5 234 348
- US-A- 5 388 995
- US-A1- 2002 172 010
- US-A1- 2003 016 520
- US-A1- 2004 050 569

## Description

La présente invention concerne d'une manière générale les cabinets pour équipement avionique.

Les cabinets pour équipement avionique sont des boitiers embarqués dans un aéronef, et contenant un certain nombre de cartes électroniques pour la gestion des différentes fonctions de l'aéronef.

Ils sont en général placés dans un espace situé sous le cockpit de aéronef, appelé baie avionique. Cet espace offre des conditions favorables aux équipements électroniques, en particulier une pression et une température maîtrisées. L'accessibilité à cet espace est facilitée par la porte d'accès à la soute de l'aéronef, généralement située à proximité.

Les cabinets sont disposés dans des meubles sur des étagères par l'intermédiaire d'éléments en double équerre appelés chaises. Les meubles permettent de fixer les cabinets dans la baie et de les connecter aux câbles de l'aéronef. Une ventilation pour le refroidissement de l'électronique est prévue via les étagères.

Pour faciliter la maintenance des avions, les équipements avioniques doivent être rapidement déconnectables et interchangeables avec d'autres équipements. A cet effet, on prévoit des fiches sur la face arrière des cabinets et, en regard, des connecteurs correspondants sur les chaises.

Ces connecteurs sont des connecteurs de type rackable, c'est-à-dire qu'ils ne nécessitent pas d'intervention particulière pour que les fiches s'y connectent correctement. Lors des opérations de maintenance on peut donc installer et retirer un cabinet d'une chaise à la manière d'un tiroir sans se soucier des connections.

Ces contraintes pénalisent toutefois le coût, le volume et le poids de l'ensemble.

En effet, les connecteurs doivent être flottants, c'est-à-dire montés libres en déplacement latéral dans la chaise pour rattraper les erreurs d'alignement entre le connecteur et la fiche, et assurer ainsi l'interchangeabilité des cabinets dans une chaise. Ces contacts flottants sont d'une grande complexité technique et sont par conséquent coûteux. De plus, le connecteur doit être très robuste car il doit reprendre les efforts d'accélération générés par les vibrations et les lois de vol de l'aéronef. Il en résulte un volume et une densité important pour le connecteur, ce qui se traduit par un poids élevé.

On connaît du document US2004/0050569A de tels cabinets avec des chaises et des étagères associées.

De tels cabinets présentent par ailleurs un certain nombre d'autres inconvénients.

Comme expliqué plus haut, une ventilation de l'électronique est assurée via l'étagère. A cet effet, l'étagère présente un profil en gouttière dont la chaise vient fermer la section. Une circulation d'air forcée s'effectue dans l'étagère et la chaise est percée dans sa partie centrale définissant ainsi une zone de la ventilation sous le cabinet. Le cabinet présente une ouverture correspondante à la verticale de cette zone et les portions de cartes électroniques situées à la verticale de cette zone sont ainsi ventilées. La zone de ventilation des cartes électroniques à l'intérieur du cabinet est réduite à cette zone. Le refroidissement des cartes en dehors de cette zone est faible, ce qui constitue une contrainte dans la conception des cartes pour placer les éléments électroniques les plus dissipateurs.

Pour assurer l'étanchéité du système de ventilation, il est nécessaire de prévoir un joint entre la chaise et le cabinet, plus particulièrement autour du trou de ventilation prévu dans la chaise. Cependant, le joint est sollicité à chaque montage et démontage du cabinet, ce qui le rend vulnérable.

Le document US 4 646 202 décrit un cabinet pour le rangement de cartes électroniques. Les cartes sont disposées dans des rainures à l'intérieur du cabinet. Les parois du cabinet comprennent une première et une deuxième cloison interne telles qu'un premier fluide peut passer dans la cavité formée entre la première surface externe de la paroi et la première cloison interne et qu'un deuxième fluide peut passer dans la cavité formée entre la deuxième cloison interne et la surface externe de la paroi opposée à la première.

Le document US 2003/0016520 décrit des modules d'alimentation d'un dispositif de distribution de puissance électrique. Les modules sont installés dans les rainures d'un châssis monté sur un véhicule. Les modules peuvent être enlevés individuellement du châssis sans avoir à retirer le dispositif en entier. Une plaque de montage peut être installée sur chaque module pour l'enfermer dans le châssis.

Fondée sur ces observations, la présente invention a pour objet de pallier à au moins un de ces inconvénients.

D'une manière plus générale, la présente invention a pour objet de perfectionner les cabinets pour équipement avionique.

L'invention propose à cet effet un cabinet pour équipement avionique d'un aéronef, comportant :
des moyens de guidage en translation pour une pluralité de cartes électroniques, orientés de manière à assurer leur translation vers un fond de cabinet présentant une interface de raccordement, ladite interface comprenant du côté des moyens de guidage une pluralité de connecteurs destinés à coopérer avec les cartes électroniques d'équipement avionique guidées et, du côté opposé débouchant à l'extérieur du cabinet, des moyens de raccordement à un faisceau électrique de l'aéronef, et
une face de fixation présentant des moyens de fixation destinés à fixer le cabinet directement à une étagère pour équipement avionique de l'aéronef.

La présente invention propose donc de supprimer la chaise et de fixer le cabinet directement sur l'étagère sans intermédiaire, et de déplacer la fonction d'interchangeabilité des équipements électroniques au niveau des cartes électroniques.

Un avantage immédiat est le gain de poids non négligeable découlant de la suppression de la chaise. Ce gain de poids est en pratique de l'ordre de 1500 g pour un équipement d'une largeur de 260 mm.

De plus, avantageusement, la fonction d'interchangeabilité (aussi appelée fonction de rackabilité) est déplacée au niveau des cartes. En cas de panne électronique, ceci permet une modularité affinée à l'échelle de la carte et non plus du cabinet tout entier, les autres cartes pouvant donc continuer à fonctionner. D'autre part, ceci permet de rendre plus facile et plus légère l'opération de réparation pour l'intervenant.

La connectique s'en trouve simplifiée, et il n'y a plus besoin de connecteurs flottants pour compenser l'alignement, puisque l'interchangeabilité se fait au niveau des cartes qui sont guidées en translation vers leurs connecteurs respectifs. Ces connecteurs ne subissent pas les contraintes de robustesse évoquées plus haut, et sont donc moins volumineux et plus légers. Il en résulte donc un gain de poids et un gain de volume disponible pour l'électronique dans le cabinet.

Par ailleurs, la zone de ventilation est maximisée car la face inférieure du cabinet peut être percée sur toute la surface de l'étagère.

Il n'y a plus besoin de joint entre la chaise et le cabinet, la chaise étant supprimée et la fonction d'interchangeabilité étant déplacée à l'intérieur du cabinet. Ceci se traduit par un gain de poids et un coût réduit.

Enfin, la suppression de la chaise a une influence avantageuse sur la réduction du poids et des coûts et offre aussi un gain d'épaisseur verticalement, ce qui se traduit par autant de gain d'espace pour l'électronique dans un volume équivalent. En pratique, ce gain de volume est de l'ordre de 3%.

Selon des caractéristiques avantageuses :
- ladite interface est une carte-mère fixée audit fond de cabinet et en ce que ladite carte-mère porte, sur la face située du côté des moyens de guidage, des connecteurs de raccordement pour les cartes électroniques guidées et, sur la face opposée, des connecteurs de raccordement au faisceau électrique de l'aéronef.

Ainsi, avantageusement, l'assemblage de l'ensemble est facilité, et l'encombrement des connecteurs à l'intérieur et à l'extérieur du cabinet est limité, ce qui, pour un même volume extérieur laisse plus de place pour l'électronique. En pratique, ce gain est de l'ordre de 40 mm en profondeur.

Selon des caractéristiques avantageuses :
- les moyens de fixation sont des trous pratiqués dans la face de fixation du cabinet et qui sont destinés à coopérer avec des ensembles vis/écrous de fixation traversant des trous de fixation prévus à cet effet dans l'étagère ;
- les moyens de fixation sont des éléments taraudés prévus dans la face de fixation du cabinet et qui sont destinés à coopérer avec des vis de fixation traversant des trous de fixation prévus à cet effet dans l'étagère.

Ainsi, avantageusement, la partie inférieure du cabinet constitue une portion filetée, il n'est pas nécessaire de prévoir de l'espace dans le cabinet entre les cartes, pour le passage d'un outil de serrage d'un éventuel écrou, et les cartes peuvent avantageusement occuper l'espace libéré à l'aplomb des vis de fixation.

Selon des caractéristiques avantageuses, éventuellement combinées :
- une rainure percée de trous pour des vis de fixation est prévue dans la face de fixation et la rainure présente une largeur dimensionnée pour retenir en rotation un écrou de fixation correspondant,
- la face de fixation du cabinet est percée d'une pluralité de trous répartis sur sa surface pour favoriser la ventilation des cartes destinées à y être montées.

Ainsi, le volume de ventilation à l'intérieur du cabinet s'en trouve maximisé.

L'invention vise en outre, selon un second aspect, une étagère pour un cabinet d'équipement avionique présentant un profil en gouttière et une pluralité de rails disposés transversalement sur le profil de gouttière, les rails étant espacés d'un pas inférieur à la largeur du plus petit cabinet que l'étagère est destinée à accueillir.

L'invention vise en outre, selon un autre aspect, un ensemble de cabinet et d'étagère pour équipement avionique tels que décrits supra et dans lequel le cabinet présente un joint d'étanchéité le long de l'un des bords de la face de fixation destiné à fermer le profil en gouttière de l'étagère, et dans lequel l'un des éléments du groupe :
étagère, rails,
présente l'un des éléments du groupe :
plot, trou,
et en ce que la face de fixation présente l'autre des éléments du groupe :
plot, trou,
disposés et dimensionnés de manière à ce que, lors de la mise en place du cabinet, celui-ci repose sur le plot, le plot étant dimensionné de manière à maintenir le joint au dessus du plan supérieur des rails.

Suivant un aspect avantageux, au moins un rail est fixé sur l'étagère par une vis et le plot est formé par la tête de vis de fixation du rail sur le cabinet.

L'invention vise en outre, selon un autre aspect, un aéronef équipé d'au moins un cabinet, une étagère ou un ensemble tels que décrits supra.

### BREVE DESCRIPTION DES DESSINS

L'exposé de l'invention sera maintenant poursuivi par la description détaillée d'un exemple de réalisation, donnée ci-après à titre illustratif et non limitatif, en référence aux dessins annexés. Sur ceux-ci :
- la figure 1 est une vue en perspective d'un cabinet pour équipement avionique monté sur une étagère selon l'invention ;
- la figure 2 est une vue en perspective éclatée du même cabinet dans lequel une pluralité de cartes électroniques sont montées ;
- la figure 3 est une vue en perspective de l'arrière du même cabinet;
- la figure 4 est une vue en perspective avant d'un mode de réalisation alternatif d'un cabinet selon l'invention ;
- la figure 5A est une vue en coupe d'un premier mode de réalisation d'un cabinet et d'une étagère selon l'invention en position intermédiaire de montage ;
- la figure 5B est une vue du même cabinet selon l'invention en position finale de montage ;
- la figure 6A est une vue en coupe d'un mode de réalisation alternatif d'un cabinet et d'une étagère selon l'invention en position intermédiaire de montage ;
- la figure 6B est une vue en coupe du même cabinet selon l'invention, en position finale de montage ;
- la figure 7A est une vue en coupe d'un autre mode de réalisation alternatif d'un cabinet et d'une étagère selon l'invention en position intermédiaire de montage ;
- la figure 7B est une vue en coupe du même cabinet selon l'invention, en position finale de montage.

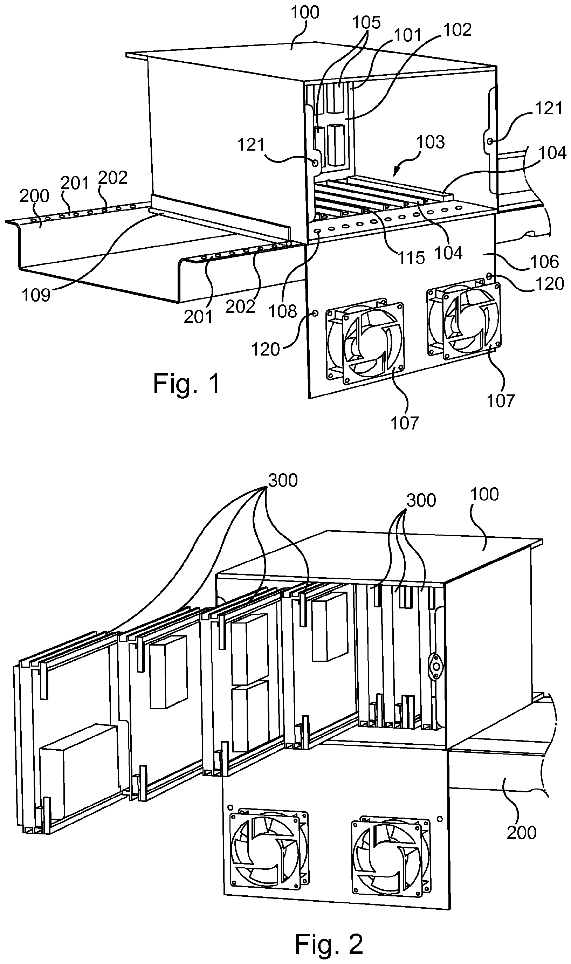

Comme visible en figure 1, un cabinet pour équipement avionique d'un aéronef présente un boitier avec cinq faces, en particulier une face de fond 101 sur laquelle est montée une carte mère 102, et une face de connexion 103 qui présente des moyens de guidage 104 en translation pour une pluralité de cartes électroniques 300. La carte mère 102 constitue une interface de raccordement, présentant du côté des moyens de guidage une pluralité de connecteurs 105 destinés à coopérer avec les cartes électroniques 300 insérées dans le cabinet et guidées par les moyens de guidage 104 comme visible plus particulièrement en figure 2. Le cabinet présente en outre une sixième face articulée 106 qui porte deux ventilateurs électriques 107 destinés à contribuer à créer un courant d'air de refroidissement à l'intérieur du cabinet. La face de fixation 103 présente en outre des trous de fixation 108 destinés à coopérer avec des ensembles vis-écrou non représentés, traversant des trous de fixation prévus à cet effet dans une étagère 200, sur laquelle le cabinet est fixé.

Comme visible plus particulièrement en figure 1, l'étagère 200 présente en section transversale un profil en forme de gouttière avec deux rebords 201 servant d'appui et de zone de fixation pour le cabinet via des trous 202. Une ventilation de l'électronique est assurée par l'étagère, dans laquelle une circulation d'air forcée s'effectue à l'aide d'un dispositif d'aération de l'aéronef disponible dans la baie avionique. Le cabinet 100 vient fermer le profil ouvert de la gouttière et la face de fixation 103 du cabinet est percée d'une pluralité de trous non représentés permettant une circulation d'air entre les cartes électroniques 300 pour évacuer la chaleur générée par celles-ci.

Pour assurer l'étanchéité de ce système, chaque cabinet est pourvu d'un joint d'étanchéité 109 collé le long de l'une de ses arêtes inférieures destinées à être à proximité immédiate du cabinet voisin ou d'une paroi non représentée en fin d'étagère, afin d'assurer l'étanchéité du système de ventilation.

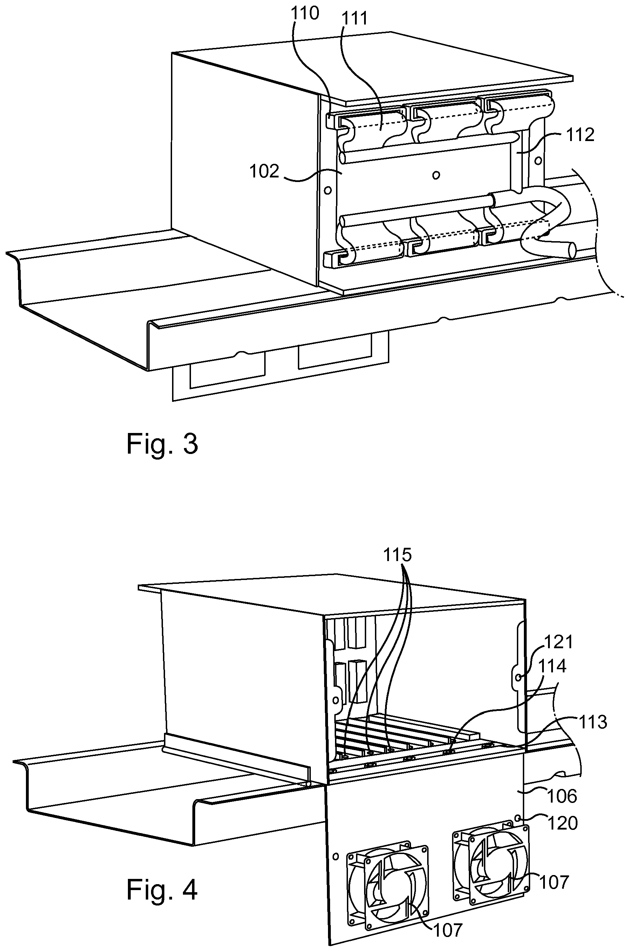

Comme visible plus particulièrement en figure 3, la face arrière du cabinet présente sur la carte mère 102 une pluralité de connecteurs 110 reliés chacun via une nappe 111 à un faisceau 112, lui-même relié au faisceau électrique de l'aéronef (non représenté). Ainsi, on comprend que la fonction d'interchangeabilité des cartes, comme visible plus particulièrement en figure 2, est déplacée à l'échelle de la carte électronique elle-même, ce qui permet aux cartes restantes du cabinet de fonctionner lorsqu'une carte tombe en panne et se trouve retirée pour réparation. La connectique arrière se trouve également simplifiée grâce au connecteur 110 porté par la carte mère et il n'y a plus besoin d'utiliser des connecteurs flottants pour compenser un éventuel décalage d'alignement. Ces dispositions contribuent à alléger l'ensemble, à en réduire le coût et à en augmenter la fiabilité. De plus, les connecteurs sont moins volumineux et il en résulte un gain de volume disponible pour l'électronique dans le cabinet pour un même volume total. En pratique, le gain de volume gagné par rapport au cabinet connu grâce au connecteur porté par l'interface de raccordement au fond du cabinet est de l'ordre de 40 mm.

Le cabinet est fixé directement sur l'étagère par l'intermédiaire de trous pratiqués dans le cabinet et dans les ailes de l'étagère. Suivant un mode de réalisation avantageux, les trous prévus dans la face de fixation du cabinet sont taraudés et prévus pour coopérer avec des vis de fixation traversant les trous de fixation des étagères. Alternativement, on prévoit des écrous à sertir sur la face de fixation du cabinet. Suivant un mode de réalisation alternatif représenté en figure 4, il est prévu une rainure 113 sur le côté intérieur de la face de fixation du cabinet. La rainure est percée d'une pluralité de trous en son fond pour accueillir des vis de fixation traversant les trous prévus à cet effet dans l'étagère. La largeur de la rainure est dimensionnée de manière à retenir en rotation des écrous 114 à six pans.

Comme visible plus particulièrement en figure 4, une pluralité de trous 115 est prévue dans la face de fixation du cabinet pour favoriser la ventilation des cartes électroniques destinées à être montées.

On comprendra que selon l'invention, avantageusement, la zone de ventilation à l'intérieur du cabinet est maximisée dans la mesure où il n'y a pas d'élément intermédiaire entre le cabinet et l'étagère. Ceci permet une zone de ventilation plus importante à l'intérieur du cabinet.

Comme visible sur les figures 1 à 4, l'étagère présente deux surfaces d'appui formant le rebord 201 en partie avant et en partie arrière. Ainsi, lorsqu'on installe le cabinet sur l'étagère, il existe le risque que le cabinet tombe à l'intérieur de la gouttière de l'étagère. Pour pallier à ce risque d'endommager la structure de l'étagère, il est envisagé dans un mode de réalisation avantageux de mettre en place une pluralité de rails 400 fixés à intervalles prédéterminés entre les deux rebords de l'étagère. Les intervalles d'espacement des rails sont déterminés de manière à être inférieurs à la largeur du plus petit cabinet destiné à être monté sur l'étagère. Ainsi, on prévient le risque de chute du cabinet à l'intérieur de l'étagère.

Suivant un premier mode de réalisation non représenté, les rails peuvent être intégrés directement à la structure de l'étagère.

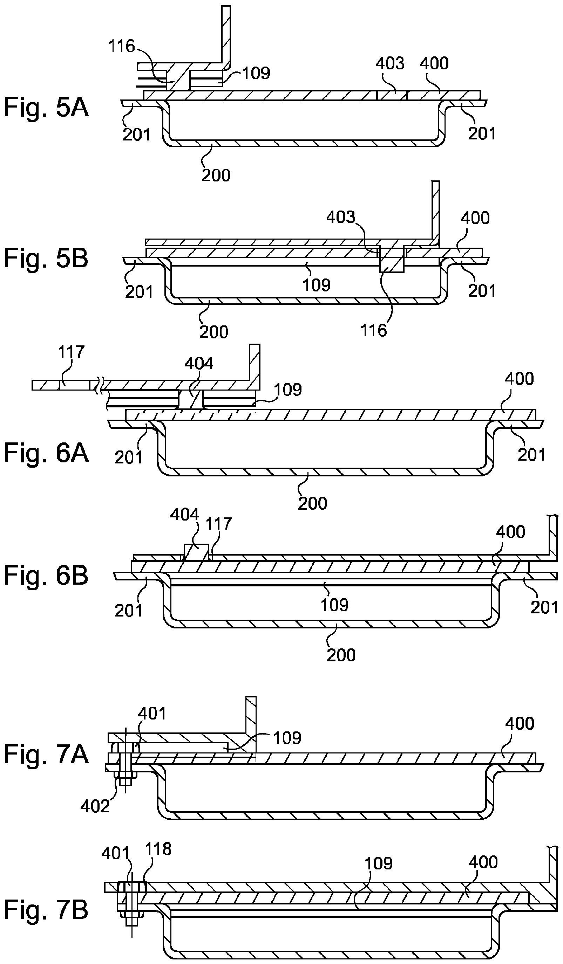

Suivant un deuxième mode de réalisation tel qu'illustré aux figures 5A à 6B, les rails sont soudés sur la partie supérieure de l'étagère, et intégrés dans le volume du cabinet par des rainures ou des découpes prédéterminées.

Suivant un troisième mode de réalisation, les rails sont vissés aux rebords 201 de l'étagère par l'intermédiaire de vis 401 coopérant avec des écrous correspondants 402. Comme expliqué plus haut, un joint 109 collé sur l'arête du cabinet est utilisé pour assurer l'étanchéité entre différents cabinets montés sur l'étagère. Pour éviter les éventuelles détériorations de ce joint lors des phases de manipulation du cabinet, en particulier lors de son montage et démontage de l'étagère, il a été prévu des plots dimensionnés de manière suffisamment haute pour maintenir le joint hors de contact avec la surface supérieure des rails lors de l'installation. Selon un premier mode de réalisation visible en figures 5A et 5B, un plot 116 est prévu sur la face inférieure de la face de fixation du cabinet. Ce plot est dimensionné de manière à avoir une hauteur supérieure à la hauteur du joint en position de repos. De cette manière, lors de l'installation du cabinet sur l'étagère, le joint ne touche pas la surface supérieure du rail 400. Une fois atteint sa position finale en figure 5B, le plot 116 rencontre une ouverture 403 judicieusement pratiquée dans le rail, et le joint se retrouve ainsi positionné à l'intérieur de la gouttière.

Dans un mode de réalisation alternatif visible en figures 6A et 6B, un plot 404 est positionné sur le rail et dimensionné de la même façon que dans le mode de réalisation précédent, afin de préserver le joint lors de l'installation du cabinet sur l'étagère. Une fois le cabinet en position finale, le plot 404 rencontre une ouverture 117 pratiquée dans la face de fixation du cabinet et le joint se trouve placé à l'intérieur de la gouttière, de façon analogue au mode de réalisation précédent.

Dans un troisième mode de réalisation particulièrement avantageux tel que visible en figures 7A et 7B, le rail 400 est fixé à l'étagère à l'aide d'une vis 401. La tête de ladite vis 401 est mise à profit pour servir de plot de manière analogue au mode de réalisation représenté aux figures 6A et 6B. Une ouverture 118 est judicieusement placée dans la face inférieure du cabinet de manière à ce que le joint se place dans la gouttière une fois que le cabinet a atteint la position finale.

Dans un mode de réalisation non représenté, deux zones de reprise de masse sont prévues en partie avant et en partie arrière au niveau des ailes 201 de l'étagère.

Comme visible plus particulièrement en figure 4, la face 106 avant du cabinet est une zone d'accès privilégié aux cartes électroniques installées à l'intérieur. C'est par cette face que l'opérateur peut installer et extraire les différentes cartes électroniques du cabinet. Dans le mode de réalisation représenté en figures 1 et 4, cette face 106 est articulée au niveau de son arête inférieure avec la face de fixation du cabinet. Cette face avant articulée porte deux ventilateurs 107 destinés à augmenter la circulation de l'air à l'intérieur du cabinet pour favoriser l'évacuation de la chaleur générée par les cartes électroniques. Des moyens de verrouillage 120,121 de la face articulée en position fermée sont prévus sur les deux faces adjacentes du cabinet. Il s'agit ici de trous de vis 120 dans la face 106 et de trous taraudés 121 correspondants venant en saillie depuis les faces latérales du cabinet.

Suivant un autre mode de réalisation non représenté, il est prévu deux faces articulées formant porte.

Suivant un autre mode de réalisation non représenté, il est prévu une face formant capot démontable.

Suivant un autre mode de réalisation non représenté, la face avant du cabinet peut être laissée ouverte en laissant visibles les modules électroniques se trouvant à l'intérieur du cabinet.

Suivant un mode de réalisation non représenté, les faces latérales du cabinet sont des capots structurels qui peuvent avantageusement être définis de façon à être identiques.

De nombreuses autres variantes sont possibles en fonction des circonstances, et l'on rappelle à cet égard que l'invention ne se limite pas aux exemples décrits et représentés.

## Revendications

1. Ensemble comprenant au moins un cabinet pour équipement avionique et une étagère, **caractérisé en ce que** l'étagère (200) présente un profil en gouttière avec deux rebords (201) et comprend une pluralité de rails (400) disposés transversalement sur les rebords, les rails étant espacés d'un pas inférieur à la largeur du plus petit cabinet que l'étagère est destinée à accueillir, et **en ce que** le cabinet présente la forme d'un boîtier ayant au moins une face de fond (101) et une face de fixation (103) présentant des moyens de fixation (108) destinés à fixer le cabinet directement à ladite étagère (200) et des :
moyens de guidage (104) en translation pour une pluralité de cartes électroniques d'équipement avionique (300), lesdits moyens de guidage étant orientés de manière à assurer la translation desdites cartes électroniques vers la face de fond (101) de cabinet présentant une interface de raccordement (102), ladite interface comprenant :
du côté des moyens de guidage, une pluralité de connecteurs (105) destinés à coopérer avec les cartes électroniques d'équipement avionique et,
du côté opposé aux moyens de guidage débouchant à l'extérieur dudit cabinet, des moyens de raccordement à un faisceau électrique de l'aéronef.

2. Ensemble selon la revendication 1, **caractérisé en ce que** ladite interface est une carte-mère (102) fixée audit fond de cabinet et **en ce que** ladite carte-mère porte, sur sa face située du côté des moyens de guidage, des connecteurs (105) de raccordement pour les cartes électroniques guidées et, sur sa face opposée, des connecteurs de raccordement au faisceau électrique de l'aéronef.

3. Ensemble selon la revendication 1 ou 2, **caractérisé en ce que** les moyens de fixation sont des trous (108) pratiqués dans la face de fixation (103) du cabinet et qui sont destinés à coopérer avec des ensembles vis/écrous de fixation traversant des trous de fixation prévus à cet effet dans l'étagère.

4. Ensemble selon la revendication 1 ou 2, **caractérisé en ce que** les moyens de fixation sont des éléments taraudés (114) prévus dans la face de fixation du cabinet et qui sont destinés à coopérer avec des vis de fixation traversant des trous de fixation (108) prévus à cet effet dans l'étagère.

5. Ensemble selon la revendication 4, **caractérisé en ce qu'**une rainure percée de trous pour des vis de fixation est prévue dans la face de fixation du cabinet ; la rainure (113) présentant une largeur dimensionnée pour retenir en rotation lesdits écrous (114) de fixation..

6. Ensemble selon l'une des revendications 1 à 5, **caractérisé en ce que** la face de fixation du cabinet est percée d'une pluralité de trous (115) répartis sur sa surface pour favoriser la ventilation des cartes destinées à être montées dans le cabinet.

7. Ensemble selon la revendication 1, **caractérisé en ce que** le cabinet présente, un joint d'étanchéité (109) le long de l'un des bords de la face de fixation qui est destinée à fermer le profil en gouttière de l'étagère, et **en ce que** l'un des éléments du groupe :
étagère, rails,
comprend l'un des éléments du groupe :
plot (116, 404, 401), trou (403, 117, 108),
et **en ce que** la face de fixation comprend l'autre des éléments du groupe :
plot, trou,
lesdits éléments étant disposés et dimensionnés de manière à ce que, lors de la mise en place du cabinet, le cabinet repose sur le plot, le plot étant dimensionné de manière à maintenir le joint (109) hors de contact de la surface supérieure des rails.

8. Ensemble selon la revendication précédente, dans lequel au moins un rail est fixé sur l'étagère par une vis (401) et le plot est formé par la tête de vis de fixation du rail sur l'étagère

## Patentansprüche

1. Anordnung, umfassend mindestens einen kleinen Raum für Avionikausrüstung und ein Regal, **dadurch gekennzeichnet, dass** das Regal (200) ein Rinnenprofil mit zwei Rändern (201) aufweist und mehrere Schienen (400) umfasst, die auf den Rändern quer angeordnet sind, wobei die Schienen um eine Distanz beabstandet sind, die geringer als die Breite des kleinsten Raums ist, den das Regal aufnehmen soll, und dadurch, dass der kleine Raum die Form eines Kastens aufweist, der mindestens eine Hinterseite (101) und eine Befestigungsseite (103), die Befestigungsmittel (108) aufweist, die dazu bestimmt sind, den kleinen Raum direkt an dem Regal (200) zu befestigen, aufweist, sowie:
Mittel (104) zur translatorischen Führung für mehrere elektronische Avionikausrüstungskarten (300), wobei die Führungsmittel derart ausgerichtet sind, dass die Translation der elektronischen Karten zu der Hinterseite (101) des kleinen Raums, die eine Anschlussschnittstelle (102) aufweist, sichergestellt ist, die Schnittstelle umfassend:
auf der Seite der Führungsmittel mehrere Steckverbinder (105), die dazu bestimmt sind, mit den elektronischen Avionikausrüstungskarten zusammenzuwirken, und
auf der Seite gegenüber den Führungsmitteln, die zum Äußeren des kleinen Raums führt, Mittel zum Anschließen an einen Kabelbaum des Luftfahrzeugs.

2. Anordnung nach Anspruch 1, **dadurch gekennzeichnet, dass** die Schnittstelle eine Hauptplatine (102) ist, die an der Hinterseite des kleinen Raums befestigt ist, und dadurch, dass die Hauptplatine auf ihrer Seite, die sich auf der Seite der Führungsmittel befindet, Steckverbinder (105) zum Anschließen für die geführten elektronischen Karten, und auf ihrer gegenüberliegenden Seite Steckverbinder zum Anschließen an den Kabelbaum des Luftfahrzeugs aufweist.

3. Anordnung nach Anspruch 1 oder 2, **dadurch gekennzeichnet, dass** die Befestigungsmittel Löcher (108) sind, die in der Befestigungsseite (103) des kleinen Raums vorgesehen sind und die dazu bestimmt sind, mit Anordnungen von Befestigungsschrauben/ -muttern zusammenzuwirken, die Befestigungslöcher durchqueren, die zu diesem Zweck in dem Regal vorgesehen sind.

4. Anordnung nach Anspruch 1 oder 2, **dadurch gekennzeichnet, dass** die Befestigungsmittel Gewindeelemente (114) sind, die in der Befestigungsseite des kleinen Raums vorgesehen sind und die dazu bestimmt sind, mit Befestigungsschrauben zusammenzuwirken, die Befestigungslöcher (108) durchqueren, die zu diesem Zweck in dem Regal vorgesehen sind.

5. Anordnung nach Anspruch 4, **dadurch gekennzeichnet, dass** eine Rille, die von Löchern für Befestigungsschrauben durchbohrt ist, in der Befestigungsseite des kleinen Raums vorgesehen ist; wobei die Rille (113) eine Breite aufweist, die dazu bemessen ist, die Befestigungsmuttern (114) in der Drehung festzuhalten.

6. Anordnung nach einem der Ansprüche 1 bis 5, **dadurch gekennzeichnet, dass** die Befestigungsseite des kleinen Raums von mehreren Löchern (115) durchbohrt ist, die auf deren Fläche verteilt sind, um die Belüftung der Karten zu begünstigen, die in dem kleinen Raum angebracht werden sollen.

7. Anordnung nach Anspruch 1, **dadurch gekennzeichnet, dass** der kleine Raum eine Dichtung (109) entlang einem der Ränder der Befestigungsseite aufweist, die dazu bestimmt ist, das Rinnenprofil des Regals zu schließen, und dadurch, dass eins der Elemente der Gruppe:
Regal, Schienen,
eins der Elemente der Gruppe:
Block (116, 404, 401), Loch (403, 117, 108), umfasst, und dadurch, dass die Befestigungsseite das andere der Elemente der Gruppe:
Block, Loch, umfasst,
wobei die Elemente derart angeordnet und bemessen sind,
dass beim Einbau des kleinen Raums der kleine Raum auf dem Block ruht, wobei der Block derart bemessen ist,
dass die Dichtung (109) außer Kontakt von der oberen Fläche der Schienen gehalten wird.

8. Anordnung nach dem vorhergehenden Anspruch, wobei mindestens eine Schiene durch eine Schraube (401) an dem Regal befestigt ist und der Block von dem Kopf der Befestigungsschraube der Schiene auf dem Regal gebildet ist.

## Claims

1. Assembly comprising at least one cabinet for avionics equipment and a shelf, **characterized in that** the shelf (200) has a trough-shaped profile with two edges (201) and comprises a plurality of rails (400) arranged transversely on the edges, the rails being spaced apart by a gap smaller than the width of the smallest cabinet that the shelf is intended to receive, and **in that** the cabinet is in the form of a housing having at least one bottom face (101) and a fastening face (103) having fastening means (108) that are intended for fastening the cabinet directly to said shelf (200) and:
guide means (104) for guiding a plurality of avionics equipment electronic boards (300) in translation, said guide means being oriented so as to ensure the translation of said electronic boards towards the cabinet bottom face (101) that has a connection interface (102), said interface comprising:
on the side of the guide means, a plurality of connectors (105) intended to interact with the avionics equipment electronic boards, and,
on the side opposite the guide means, emerging on the outside of said cabinet, means for connecting to a wiring harness of the aircraft.

2. Assembly according to Claim 1, **characterized in that** said interface is a motherboard (102) fastened to said cabinet bottom, and **in that** said motherboard carries, on its face situated on the side of the guide means, connectors (105) for the connection of the guided electronic boards and, on its opposite face, connectors for connection to the wiring harness of the aircraft.

3. Assembly according to Claim 1 or 2, **characterized in that** the fastening means are holes (108) formed in the fastening face (103) of the cabinet and that are intended to interact with screw/nut fastening assemblies passing through fastening holes that are provided in the shelf for this purpose.

4. Assembly according to Claim 1 or 2, **characterized in that** the fastening means are tapped elements (114) provided in the fastening face of the cabinet and that are intended to interact with fastening screws passing through fastening holes (108) that are provided in the shelf for this purpose.

5. Assembly according to Claim 4, **characterized in that** a groove pierced with holes for fastening screws is provided in the fastening face of the cabinet, the groove (113) having a width that is dimensioned so as to hold said fastening nuts (114) in rotation.

6. Assembly according to one of Claims 1 to 5, **characterized in that** the fastening face of the cabinet is pierced with a plurality of holes (115) distributed over its surface so as to promote the ventilation of the boards that are intended to be mounted in the cabinet.

7. Assembly according to Claim 1, **characterized in that** the cabinet has a gasket (109) along one of the edges of the fastening face that is intended to close the trough-shaped profile of the shelf, and **in that** one of the elements from the group:
shelf, rails,
comprises one of the elements from the group:
stud (116, 404, 401), hole (403, 117, 108),
and **in that** the fastening face comprises the other of the elements from the group:
stud, hole,
said elements being positioned and dimensioned such that, when the cabinet is installed, the cabinet rests on the stud, the stud being dimensioned so as to keep the gasket (109) out of contact with the upper surface of the rails.

8. Assembly according to the preceding claim, wherein at least one rail is fastened to the shelf by a screw (401), and the stud is formed by the head of the screw for fastening the rail to the shelf.
